# NEUE EUROPÄISCHE PATENTSCHRIFT

(11) **EP 2 356 894 B2**
(45) Veröffentlichungstag und Bekanntmachung des Hinweises auf die Entscheidung über den Einspruch: **25.01.2017**
(45) Hinweis auf die Patenterteilung: 14.08.2013
(21) Anmeldenummer: 09783448.5
(22) Anmeldetag: 28.09.2009
(51) Int. Cl.: H05K 7/20, H01L 23/473, H01L 25/07

(54) **STROMRICHTERMODUL MIT GEKÜHLTER VERSCHIENUNG**
POWER CONVERTER MODULE HAVING A COOLED BUSBAR
MODULE REDRESSEUR DE COURANT AVEC RAILS REFROIDIS

(30) Priorität: 10.12.2008 DE 102008061489
(43) Veröffentlichungstag der Anmeldung: 17.08.2011
(73) Patentinhaber: Siemens Aktiengesellschaft, 80333 München (DE)
(72) Erfinder: BOTT, Stefan, 90425 Nürnberg (DE); KOLK, Wilfried, 91052 Erlangen (DE)
(86) Internationale Anmeldenummer: PCT/EP2009/062480
(87) Internationale Veröffentlichungsnummer: WO 2010/066482

(56) Entgegenhaltungen:
- WO-A1-2005/109505
- WO-A2-2007/028039
- DE-A1-102007 003 875
- JP-A- 2006 271 063
- US-B1- 6 604 571

## Beschreibung

Die Erfindung bezieht sich auf ein Stromrichtermodul gemäß Oberbegriff des Anspruchs 1.

Gattungsgemäße Stromrichtermodule, insbesondere für höhere Leistungen, sind im Handel erhältlich. Bei derartigen Stromrichtermodulen sind dessen Leistungshalbleitermodule, insbesondere abschaltbare Leistungshalbleitermodule, mit Anschlüssen des Stromrichtermoduls niederinduktiv verschient. Dies wird dadurch erreicht, dass die verwendeten Stromschienen flächig ausgeführt und übereinander zu einem Stromschienenstapel gestapelt sind. Jeweils zwischen zwei flächigen Stromschienen ist eine flächig ausgeführte Isolierschicht angeordnet. Diese Isolierschichten überragen die flächigen Stromschienen, damit Grenzwerte für Luft- und Kriechstrecken eingehalten werden können. Somit weist eine derartige niederinduktive Verschienung mindestens zwei Stromschienen und mindestens eine Isolierschicht auf. Um die Verschienung der verwendeten Leistungshalbleitermodule des Stromrichtermoduls möglichst kompakt zu gestalten, ist dieses Schienenpaket laminiert. Durch das verwendete Laminiermaterial weist diese laminierte Verschienung eine Temperaturgrenze von beispielsweise 105° C auf.

Da bei den im Handel erhältlichen Leistungshalbleitermodulen, insbesondere abschaltbare Leistungshalbleitermodule, beispielsweise **I**nsulated-**G**ate-**B**ipolar-**T**ransistor (IGBT), die Stromtragfähigkeit stetig zunimmt, steigt dementsprechend die Stromdichte in den Stromschienen einer laminierten Verschienung eines Stromrichtermoduls an. Dies hat eine quadratische Zunahme der Verluste in der laminierten Verschienung zur Folge, so dass die Temperatur dieser laminierten Verschienung ebenfalls zunimmt. Die Grenztemperatur einer laminierten Verschienung wird durch die eingesetzten Materialien der Isolierschichten und des Laminiermaterials bestimmt. Bevorzugt kommen derzeit in Strömrichtermodulen mit einer Isolierfolie laminierte Verschienungen zum Einsatz. Hier setzt das Laminiermaterial der laminierten Verschienung eine Temperaturgrenze. Für Stromrichteranwendungen bedeutet dies eine Leistungsbegrenzung, die nicht mehr durch die eingesetzten Leistungshalbleitermodule, sondern durch die maximale Grenztemperatur des entsprechenden Laminiermaterials der Verschienung bedingt ist.

Naheliegende Lösungen dieses Problems sind einerseits, den Querschnitt einer jeden Stromschiene der laminierten Verschienung zu erhöhen, und andererseits die laminierte Verschienung zu kühlen, beispielsweise durch Eigenkonvektion. Durch die Erhöhung der Querschnitte der Stromschienen der laminierten Verschienung ist eine derartige Verschienung nicht nur kostspieliger, sondern weist auch ein höheres Gewicht auf. Um die laminierte Verschienung durch Eigenkonvektion zu kühlen, muss diese in einem Stromrichtergerät derart angeordnet werden, dass ein Kühlluftstrom über die laminierte Verschienung fließen kann.

Aus der WO 2005/109505 A1 ist eine Leistungshalbleiterschaltung bekannt, deren Verschienung gekühlt wird. Bei dieser Leistungshalbleiterschaltung ist wenigstens ein Modul auf einer als Plus- oder Minus-Platte dienenden plattenförmigen Stromschiene außenseitig aufgelötet. Die Plus- bzw. Minus-Schienen sind üblicherweise als oberste bzw. unterste Platte eines Platten-Verschienungspakets angeordnet. Diese Deckschiene, auf der das Modul aufgebracht ist, wird direkt von einer Kühleinrichtung gekühlt, wobei diese Kühleinrichtung als Luft- oder Flüssigkeitskühlung ausgebildet ist. Diese Kühleinrichtung ist sandwichartig zwischen der Deckschiene und unter Zwischenlage einer Isolierung einer weiteren, in einer parallelen Ebene liegenden plattenförmigen Stromschiene angeordnet. Ferner ist unter Zwischenlage einer weiteren Isolierschicht eine unterseitige Stromschiene vorgesehen. Diese Stromschienen bilden zusammen mit der Kühleinrichtung eine sehr kompakte Anordnung. Die Elemente dieses Verschienungspaketes sind durch Laminieren miteinander verbunden. Da es sich bei dieser Leistungshalbleiterschaltung um einen Wechselrichter handelt, sind unter diesem Verschienungspaket zwei Zwischenkreiskondensatoren angeordnet, die über Verschraubungen mit der oberen bzw. unteren Stromschiene verbunden sind.

Aus der DE 10 2007 003 875 A1 ist ein Stromrichtermodul mit wenigstens zwei Leistungshalbleitermodulen bekannt, die thermisch leitend mit einem Kühlkörper mechanisch verbunden und mittels einer laminierten Verschienung untereinander elektrisch verschaltet sind. Wenigstens eine Stromschiene dieser laminierten Verschienung ist mittels wenigstens eines elektrisch isolierenden und thermisch leitenden Stützelements mit dem Kühlkörper thermisch verknüpft. Durch diese Stützelemente ist wenigstens eine Stromschiene der laminierten Verschienung an den Kühlkörper thermisch angebunden. Die Höhe der abzuführenden Wärme bestimmt die Anzahl der thermisch leitenden Stützelemente. Mittels dieser Stützelemente wird die laminierte Verschienung in den Randbereichen ebenfalls abgestützt. Mittels dieser thermisch leitenden Stützelemente ist die Menge der von der laminierten Verschienung abzuführenden Wärmemenge beschränkt.

Der Erfindung liegt nun die Aufgabe zugrunde, ein Stromrichtermodul anzugeben, dessen laminierte Verschienung mit einfachen Mitteln entwärmt werden kann, wobei dieses Stromrichtermodul nicht neu entflechtet bzw. neu konstruiert werden muss.

Diese Aufgabe wird mit den kennzeichnenden Merkmalen des Anspruchs 1 erfindungsgemäß gelöst.

Dadurch, dass ein weiterer Flüssigkeits-Kühlkörper mit der laminierten Verschienung eines Stromrichtermoduls thermisch leitend, aber elektrisch isolierend kraft- und/oder formschlüssig verbunden ist, kann diese laminierte Verschienung großflächig entwärmt werden. Reicht die Grundfläche des weiteren Flüssigkeits-Kühlkörpers nicht aus, so kann zusätzlich die Durchflussmenge erhöht werden. Wie gut die thermische Verbindung von laminierter Verschienung und weiterem Flüssigkeits-Kühlkörper ist, hängt vom Anpressdruck ab, mit dem dieser weitere Flüssigkeits-Kühlkörper auf die laminierte Verschienung gedrückt wird. Dazu weist das erfindungsgemäße Stromrichtermodul wenigstens ein Spannelement auf.

Bei einer vorteilhaften Ausführungsform des Stromrichtermoduls nach der Erfindung sind der weitere Flüssigkeits-Kühlkörper und der Flüssigkeits-Kühlkörper des Stromrichtermoduls flüssigkeitsmäßig miteinander verknüpft. Das heißt, dass der weitere Flüssigkeits-Kühlkörper aus dem Flüssigkeitskreislauf des Stromrichtermoduls, der auch als Primärkreislauf bezeichnet wird, versorgt wird. Dies hat den Vorteil, dass das Stromrichtermodul von seinen Anschlüssen unverändert bleibt.

Weitere vorteilhafte Ausführungsformen des erfindungsgemäßen Stromrichtermoduls sind den Unteransprüchen zu entnehmen.

Zur weiteren Erläuterung der Erfindung wird auf die Zeichnung Bezug genommen, in der eine Ausführungsform schematisch veranschaulicht ist.
- FIG 1: zeigt eine vorteilhafte Ausführungsform eines Stromrichtermoduls und in der
- FIG 2: ist eine erste Ausführungsform eines Spannelementes des Stromrichtermoduls nach FIG 1 dargestellt, wobei die
- FIG 3: einen Teil einer zweiten Ausführungsform eines Spannelementes des Stromrichtermoduls nach FIG 1 zeigt.

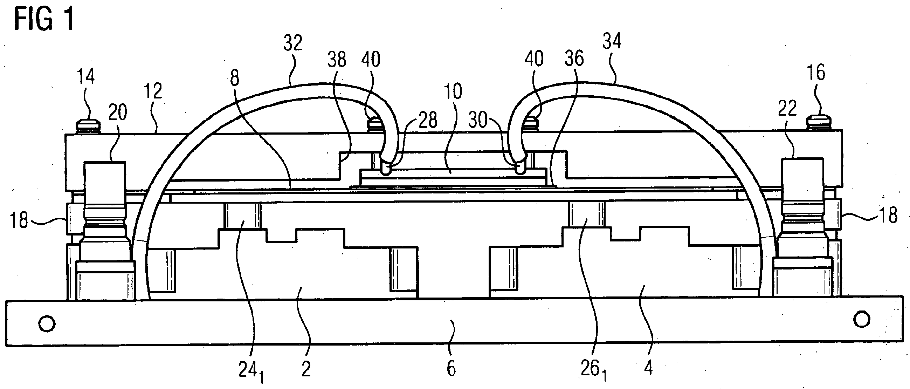

In der Figur 1, die eine Frontsicht eines Stromrichtermoduls darstellt, sind mit 2 und 4 jeweils ein Leistungshalbleitermodul, insbesondere ein abschaltbares Leistungshalbleitermodul, beispielsweise ein Insulated-Gate-Bipolar-Transistor (IGBT), mit 6 ein Flüssigkeits-Kühlkörper, mit 8 eine Verschienung, mit 10 ein weiterer Flüssigkeits-Kühlkörper, mit 12 ein Bügel, mit 14 und 16 jeweils eine Spannschraube und mit 18 Stützelemente bezeichnet. Außerdem sind in dieser Darstellung ein Kühlmittelzu- und -ablauf mit 20 und 22 bezeichnet.

Die beiden Leistungshalbleitermodule 2 und 4 sind mechanisch mit dem Flüssigkeits-Kühlkörper 6 lösbar befestigt. Die Verschienung 8, die insbesondere laminiert ist, kann zwei Stromschienen, beispielsweise eine Plus-Stromschiene und eine Last-Stromschiene bzw. eine Last-Stromschiene und eine MinusStromschiene, oder drei Stromschienen, beispielsweise eine Plus-, Last- und Minusstromschiene, aufweisen. Die Anzahl der Stromschienen einer Verschienung 8 hängt von der elektrischen Verschaltung der beiden Leistungshalbleitermodule 2 und 4 ab. Sind diese beiden Leistungshalbleitermodule 2 und 4 elektrisch parallel geschaltet, so weist diese Verschienung 8 nur zwei Stromschienen auf. Sind dagegen diese beiden Leistungshalbleitermodule 2 und 4 elektrisch in Reihe geschaltet, und bilden ein Phasenmodul eines Stromrichters, so weist diese Verschienung 8 drei Stromschienen auf. Wird das Stromrichtermodul als Phasenmodul verwendet, so sind die drei Stromschienen der vorgesehenen Verschienung 8 eine Plus-, Last- und Minusstromschiene. Diese Stromschienen sind übereinander angeordnet, wobei jeweils zwischen zwei Stromschienen eine Isolierschicht angeordnet, und insbesondere laminiert.

Diese Verschienung 8 ist auf den elektrischen Anschüssen eines jeden Leistungshalbleitermoduls 2 und 4 gesteckt, wobei von den beiden Leistungsanschlüssen jeweils nur ein Anschluss 24₁ und 26₁ dargestellt sind. Bei diesen elektrischen Anschlüssen 24₁ und 26₁ kann es sich um Lötstifte oder Schraubbolzen handeln. Ab einem vorbestimmten Leistungsvermögen des Leistungshalbleitermoduls 2, 4 weisen die Leistungshalbleitermodule 2, 4 als elektrische Anschlüsse 24 und 26 nur noch Schraubbolzen auf. Entsprechend der Verschaltung der beiden Leistungshalbleitermodule 2, 4 sind deren Anschlüsse 24, 26 jeweils mit einer vorbestimmten Stromschiene der Verschienung 8 elektrisch leitend verbunden. Diese Verschienung 8 stützt sich nicht nur auf die Anschlüsse 24, 26 der Leistungshalbleitermodule 2, 4, sondern auch auf eine Mehrzahl von Stützelementen 18 ab. Diese sind entlang jeweils einer Längsseite des Stromrichtermoduls angeordnet.

Da als Kühlkörper dieses Stromrichtermoduls ein Flüssigkeits-Kühlkörper 6 vorgesehen ist, weist dieser einen Kühlmittelzulauf 20 und einen Kühlmittelablauf 22 auf. Mit diesen Kühlmittelzu- und -abläufen 20 und 22 ist das Stromrichtermodul mit einem Kühlmittelkreislauf flüssigkeitsmäßig verbunden. Als Kühlflüssigkeit kann jede Flüssigkeit, vorzugsweise ein Wasserglykolgemisch, verwendet werden.

Da die Stromtragfähigkeit der im Stromrichtermodul verwendeten Leistungshalbleitermodule 2, 4 stetig zunimmt, steigt auch der Strom in den Stromschienen der Verschienung 8 an. Dies hat eine quadratische Zunahme der Verluste in der Verschienung 8 zur Folge. Dadurch steigt die Temperatur in der Verschienung 8 an. Wie hoch die Grenztemperatur an der Verschienung 8 sein kann, hängt von dem verwendeten Isoliermaterial ab. Das heißt, dass bei einer laminierten Verschienung 8 das Laminiermaterial dieser Verschienung 8 eine Temperaturgrenze festsetzt. Das bedeutet für Stromrichteranwendungen eine Leistungsbegrenzung, die nicht mehr durch die eingesetzten Leistungshalbleitermodule 2, 4, sondern durch die materialspezifische Grenztemperatur eines Isoliermaterials bestimmt wird.

Um die in der Verschienung 8 entstandene Verlustleistung abführen zu können, ist diese Verschienung 8 mit einem weiteren Flüssigkeits-Kühlkörper 10 versehen. Die Kühlmittelzu- und - abläufe 28 und 30 dieses weiteren Flüssigkeits-Kühlkörpers 10 sind kühlmittelmäßig jeweils mittels eines Verbindungsschlauches 32 und 34 mit dem Flüssigkeitskreislauf des Flüssigkeits-Kühlkörpers 6 verbunden. Der Flüssigkeitskreislauf des Flüssigkeits-Kühlkörpers 6 wird als Primärkreislauf und der Flüssigkeitskreislauf des weiteren Flüssigkeits-Kühlkörpers 10 als Sekundärkreislauf bezeichnet. Der Primär- und der Sekundärkreislauf können flüssigkeitsmäßig parallel oder in Reihe geschaltet sein. Dieser weitere Flüssigkeits-Kühlkörper 10 kann entgegen der Darstellung annähernd die gesamte Oberfläche der Verschienung 8 abdecken. Damit dieser weitere Flüssigkeits-Kühlkörper 10 elektrisch von dieser Verschienung 8 isoliert ist, ist eine Isolierschicht 36 vorgesehen, die aber thermisch gut leitend sein muss. Diese Isolierschicht 36 kann im einfachsten Fall mittels einer Wärmeleitpaste erzeugt werden. Damit ein Wärmeübergang effizient ist, wird der weitere Flüssigkeits-Kühlkörper 10 kraft- und/oder formschlüssig mit der Verschienung 8 verbunden.

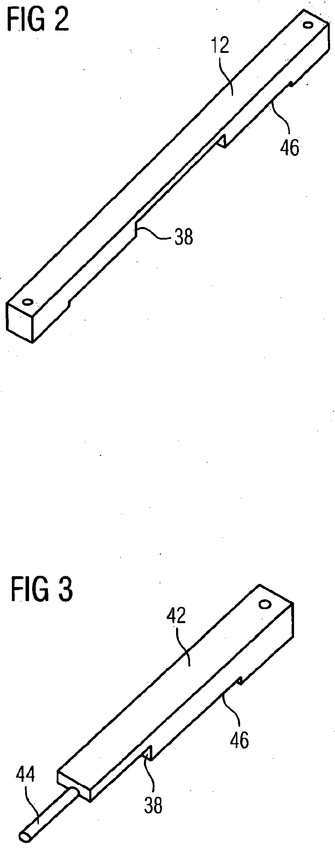

Zur Herstellung einer kraft- und/oder formschlüssigen Verbindung wird wenigstens ein Spannelement benötigt. Werden mehrere Spannelemente vorgesehen, so werden diese in Längsrichtung des weiteren Flüssigkeits-Kühlkörpers 10 verteilt angeordnet. In der dargestellten Ausführungsform ist als Spannelement ein Bügel 12 (FIG 2) mit zwei Spannschrauben 14 und 16 vorgesehen. Dieser Bügel 12 gemäß Figur 2 weist eine zu den Abmessungen des weiteren Flüssigkeits-Kühlkörpers 10 entsprechende ausgestaltete Ausnehmung 38 auf. Um den Anpressdruck des weiteren Flüssigkeits-Kühlkörpers 10 auf die Verschienung 8 einstellen zu können, weist der Bügel 12 wenigstens zwei Druckelemente 40 auf. Durch Drehen dieser Druckelemente 40 erhöht sich ein Druck auf den weiteren Flüssigkeits-Kühlkörper 10 und damit auf eine entsprechende Oberfläche der Verschienung 8.

Alternative Ausführungsformen eines Spannelementes sind eine Blattfeder oder ein Bügel 42 mit elastischem Zwischenteil 44 (FIG 3). Der Bügel 12 gemäß Figur 2 weist neben der Ausnehmung 38 für den weiteren Flüssigkeits-Kühlkörper 10 auch noch eine weitere Ausnehmung 46 auf, um sich damit an den Verlauf der Oberfläche der laminierten Verschienung 8 anpassen zu können. Wenn keine zusätzlichen Druckelemente 40 am Bügel 12 verwendet werden sollen, muss die Ausnehmung 38 so ausgestaltet sein, dass im montierten Zustand der Bügel 12 entlang des weiteren Flüssigkeits-Kühlkörpers 10 ein vorbestimmter Anpressdruck ausgeübt wird. Gemäß der Ausführungsform des Bügels 42 gemäß Figur 3 weist dieser Bügel 42 in der Mitte ein elastisches Zwischenelement 44 auf, das im montierten Zustand des Bügels 42 eine Anpresskraft auf den weiteren Flüssigkeits-Kühlkörper 10 ausübt.

Mittels dieses weiteren Flüssigkeits-Kühlkörpers 10, der mittels wenigstens einem Spannelement auf eine Oberfläche einer Verschienung 8, insbesondere einer laminierten Verschienung 8, eines Stromrichtermoduls gepresst wird, kann eine in der laminierten Verschienung 8 entstandene zusätzliche Verlustleistung abgeführt werden. Dadurch wird die Verschienungstemperatur herabgesetzt, wodurch die verwendeten Leistungshalbleitermodule 2, 4 leistungsmäßig ausgeschöpft werden können. Das heißt, das Stromrichtermodul weist eine höhere Leistung auf, ohne dass die elektrischen Anschlüsse und Flüssigkeitsanschlüsse des Stromrichtermoduls verändert werden mussten. Dadurch wird der Montage- und Demontageablauf des Stromrichtermoduls beibehalten. Da außerdem ein geforderter Flüssigkeitsdurchfluss für den Sekundärkreislauf nur einen Bruchteil des Primärkreislaufs aufweist, bleibt der konstruktive Aufbau des Stromrichtermoduls erhalten.

## Patentansprüche

1. Stromrichtermodul mit wenigstens einem Leistungshalbleitermodul (2, 4), das thermisch leitend mit einem Flüssigkeits-Kühlkörper (6) mechanisch verbunden und das mittels beiner laminierten Verschienung (8), die wenigstens zwei voneinander isolierte Stromschienen aufweist, mit Anschlüssen des Stromrichtermoduls elektrisch leitend verknüpft sind, wobei diese laminierte Verschienung (8) mit einem weiteren Flüssigkeits-Kühlkörper (10) kraft- und/oder formschlüssig verbunden ist, wobei zwischen einer oberen Stromschiene der laminierten Verschienung (8) und dem weiteren Flüssigkeits-Kühlkörper (10) eine thermisch leitende und elektrisch isolierende Schicht (36) angeordnet ist, wobei für eine kraft- und/oder formschlüssige Verbindung zwischen laminierter Verschienung (8) und weiterem Flüssigkeits-Kühlkörper (10) wenigstens ein Spannelement vorgesehen ist, wobei als Spannelement ein formschlüssiger Bügel (12) mit zwei Spannschrauben (14, 16) vorgesehen ist, wobei der formschlüssiger Bügel (12) Druckelemente (40), insbesondere zwei Druckelemente (40), aufweist, wobei der Anpressdruck des weiteren Flüssigkeits-Kühlkörper (10) auf die laminierte Verschienung (8) mittels der Druckelemente (40) durch Drehen der Druckelemente (40) einstellbar ist.

2. Stromrichtermodul nach Anspruch 1, **dadurch gekennzeichnet, dass** der weitere Flüssigkeits-Kühlkörper (10) flüssigkeitsmäßig mit dem Flüssigkeits-Kühlkörper (6) verknüpft ist.

3. Stromrichtermodul nach einem der vorgenannten Ansprüche, **dadurch gekennzeichnet, dass** der weitere Flüssigkeits-Kühlkörper (10) flächenmäßig wenigstens annähernd einen überwiegenden Teil einer Oberfläche der Verschienung (8) abdeckt.

4. Stromrichtermodul nach einem der vorgenannten Ansprüche, **dadurch gekennzeichnet, dass** die Isolierschicht (36) mit thermisch leitfähigen Interface-Materialien ausgeführt ist.

5. Stromrichtermodul nach einem der Ansprüche 1 bis 3, **dadurch gekennzeichnet, dass** die Isolierschicht (36) mit thermisch leitfähigen und elektrisch isolierenden Interface-Materialien ausgeführt ist.

## Claims

1. Power converter module comprising at least one power semiconductor module (2, 4) which is mechanically connected to a liquid cooling body (6) in a thermally conductive manner and which is electrically conductively linked to connections of the power converter module by means of a laminated busbar arrangement (8) having at least two busbars insulated from one another, wherein said laminated busbar arrangement (8) is connected to a further liquid cooling body (10) in a force-locking and/or positively locking manner, a thermally conductive and electrically insulating layer (36) being arranged between an upper busbar of the laminated busbar arrangement (8) and the further liquid cooling body (10), wherein at least one clamping element is provided for a force-locking and/or positively locking connection between laminated busbar arrangement (8) and further liquid cooling body (10), wherein a positively locking clip (12) with two clamping screws (14, 16) is provided as the clamping element, wherein the positively locking clip (12) has pressure elements (40), in particular two pressure elements (40), wherein the contact pressure of the further liquid cooling body (10) on the laminated busbar arrangement (8) is adjustable by means of the pressure elements (40) by rotation of the pressure elements (40).

2. Power converter module according to Claim 1, **characterized in that** the further liquid cooling body (10) is linked to the liquid cooling body (6) in terms of liquid.

3. Power converter module according to either of the preceding claims, **characterized in that** the further liquid cooling body (10) areally covers at least approximately a predominant portion of a surface of the busbar arrangement (8).

4. Power converter module according to any of the preceding claims, **characterized in that** the insulating layer (36) is embodied with thermally conductive interface materials.

5. Power converter module according to any of Claims 1 to 3, **characterized in that** the insulating layer (36) is embodied with thermally conductive and electrically insulating interface materials.

## Revendications

1. Module convertisseur de courant ayant au moins un module ( 2, 4 ) de puissance à semiconducteur, qui est relié mécaniquement avec conduction thermique à un dissipateur ( 6 ) de chaleur à liquide et qui est combiné d'une manière conductrice de l'électricité, au moyen de rails ( 8 ) lamellés qui ont au moins deux barres de courant isolées l'une de l'autre, à des bornes du module convertisseur, ces rails ( 8 ) lamellés étant reliés à complémentarité de force et/ou de forme à un autre dissipateur ( 10 ) de chaleur à liquide, une couche ( 36 ) conductrice thermiquement et isolante électriquement étant disposée entre un rail de courant supérieur des rails ( 8 ) lamellés et l'autre dissipateur ( 10 ) de chaleur à liquide, dans lequel il est prévu, pour une liaison à complémentarité de force et/ou de forme entre les rails ( 8 ) lamellés et l'autre dissipateur ( 10 ) de chaleur à liquide, au moins un élément de serrage, dans lequel il est prévu comme élément de serrage un étrier ( 12 ) à conformité de forme ayant deux vis ( 14, 16 ) de serrage, l'étrier ( 12 ) à complémentarité de forme étant pourvu d'éléments ( 40 ) d'application d'une pression, notamment de deux éléments ( 40 ) d'application d'une pression, la pression d'application de l'autre dissipateur ( 10 ) de chaleur à liquide sur les rails (8) lamellés étant réglable au moyen des éléments ( 40 ) d'application d'une pression par rotation des éléments ( 40 ) d'application d'une pression.

2. Module convertisseur suivant la revendication 1,
**caractérisé en ce que** l'autre dissipateur ( 10 ) de chaleur à liquide est combiné, du point de vue du liquide, au dissipateur ( 6 ) de chaleur à liquide.

3. Module convertisseur suivant l'une des revendications précédentes,
**caractérisé en ce que** l'autre dissipateur ( 10 ) de chaleur à liquide recouvre, suivant une surface, au moins à peu près une partie prépondérante d'une surface des rails ( 8 ).

4. Module convertisseur suivant l'une des revendications précédentes,
**caractérisé en ce que** la couche ( 36 ) isolante est en des matériaux d'interface conducteurs du point de vue thermique.

5. Module convertisseur suivant l'une des revendications 1 à 3,
**caractérisé en ce que** la couche ( 36 ) isolante est en des matériaux d'interface conducteurs du point de vue thermique et isolants électriquement.
